# EUROPÄISCHE PATENTSCHRIFT

(11) **EP 2 912 970 B1**
(45) Veröffentlichungstag und Bekanntmachung des Hinweises auf die Patenterteilung: **04.04.2018**
(21) Anmeldenummer: 15153737.0
(22) Anmeldetag: 04.02.2015
(51) Int. Cl.: A47B 96/20, B32B 3/12, E04C 2/36, B27D 5/00, F16B 5/01

(54) **Leichtbauplatte sowie Herstellungsverfahren**
Lightweight panel and manufacturing method
Panneau de construction léger ainsi que son procédé de fabrication

(30) Priorität: 10.02.2014 DE 102014101600
(43) Veröffentlichungstag der Anmeldung: 02.09.2015
(60) Teilanmeldung: 17174886.6
(73) Patentinhaber: Ebbinghaus, Heinrich, 33415 Verl (DE)
(72) Erfinder: Ebbinghaus, Heinrich, 33415 Verl (DE)
(74) Vertreter: Ostermann, Thomas

(56) Entgegenhaltungen:
- EP-A2- 1 698 738
- WO-A1-2009/040863
- DE-U1-202009 001 546
- US-A- 2 399 666

## Beschreibung

Die Erfindung betrifft eine Leichtbauplatte für Möbel mit zwei Decklagen und einer zwischen den beiden Decklagen angeordneten Kernlage nach dem Oberbegriff des Patentanspruchs 1.

Ferner betrifft die Erfindung ein Verfahren zur Herstellung einer Leichtbauplatte mit zwei Decklagen nach dem Oberbegriff des Patentanspruchs 10.

Aus der DE 103 13 055 B4 ist eine Leichtbauplatte für Möbel bekannt, die aus zwei Decklagen und einer zwischen denselben angeordneten Kernlage mit einer wabenartigen Struktur besteht. Die Deckplatten sind randseitig mit einer Kantenleiste verbunden, sodass die Leichtbauplatte an einer Schmalseite abgeschlossen ist. Nachteilig an der bekannten Leichtbauplatte ist, dass sich stets eine Grenzkahte zwischen der Kantenleiste einerseits und einer der beiden Decklagen andererseits bildet, sodass ein unerwünschter sichtbarer Übergang an diesen Grenzkanten sichtbar ist. Die Ausgestaltung der Kernlage durch eine Wabenstruktur verringert zwar das Gewicht der Leichtbauplatte. Nachteilig hieran ist jedoch, dass relativ aufwendig Maßnahmen getroffen werden müssen, um Befestigungsmittel bzw. Beschläge an der Leichtbauwand anzubringen.

Aus der DE 20 2009 001546 U1, US 2 399 666 A und der EP 1 698 738 A2 sind Leichtbauplatten für Möbel mit zwei Decklagen sowie einer zwischen denselben angeordneten Kernlage bekannt, wobei die Decklagen endseitig über eine Kantenleiste miteinander verbunden sind.

Aus der WO 2009/040863 A1 ist eine Leichtbauplatte für Möbel bekannt, die zwei Decklagen und eine zwischen den beiden angeordnete Kernlage aufweist. An einer Schmalseite der Leichtbauplatte ist eine Kantenleiste angeordnet. Die Kantenleisten weisen ebene Anschlagflächen auf, die jeweils an ebenfalls ebenen Anschlagflächen der beiden Decklagen anliegen. Die Kantenleiste ist derart dimensioniert, dass eine Grenzkante der Kantenleiste zu einer Grenzkante der beiden Decklagen im Montagezustand bündig aneinander liegt. Eine Ummantelung der Decklagen sowie der Kantenleiste ist nicht vorgesehen. Ferner umfasst die Kernlage eine Anzahl von Aufnahmeelementen zur Aufnahme von Befestigungsmitteln. Zwischen den Decklagen sind Stützelemente in einem Abstand zueinander angeordnet.

Aufgabe der vorliegenden Erfindung ist es daher, eine Leichtbauplatte derart weiterzubilden, dass sie einfach und kostengünstig herzustellen und ein dekoratives Erscheinungsbild frei von sichtbaren Übergängen aufweist. Ferner soll ein Verfahren zur Herstellung einer Leichtbauplatte angegeben werden, das kostengünstig einen stabilen Aufbau mit homogenen Übergängen zwischen einer Decklage und Kantenleisten gewährleistet.

Zur Lösung der Aufgabe weist die erfindungsgemäße Leichtbauplatte die Merkmale des Patentanspruchs 1 auf.

Der besondere Vorteil der Erfindung besteht darin, dass eine einfach und kostengünstig herzustellende Leichtbauwand geschaffen wird, die eine ausreichende Stabilität aufweist und zusätzlich ein homogenes durchgehendes äußeres Erscheinungsbild vermittelt. Zur Stabilisierung der Leichtbauwand besteht die Kernlage im Wesentlichen aus einer Anzahl von Stützelementen, die sich zwischen beabstandet zueinander einer ersten und einer zweiten Decklage erstrecken. Zwischen den Stützelementen bzw. endseitigen Stützelementen und der Kantenleiste werden Hohlräume gebildet, sodass das Gewicht der Leichtbauwand relativ gering gehalten werden kann. Um die Leichtbauwand mit anderen Möbelteilen, wie bspw. einer anderen Leichtbauwand, zu verbinden, weist die Leichtbauwand an den jeweiligen vorgegebenen Befestigungsstellen Aufnahmeelemente auf, die an einer Innenseite der ersten und/oder zweiten Decklage angeordnet sind. Vorzugsweise sind die Aufnahmeelemente stoffschlüssig mit der entsprechenden Decklage verbunden. Diese Aufnahmeelemente haben eine solche Erstreckung, dass bspw. ein Befestigungsbolzen in eine Bohrung des Aufnahmelementes bzw. eine entsprechend fluchtende Bohrung der Deckseite eingreifen kann. Damit die Grenzkante der Kantenleiste und der Decklage bündig aneinander liegen und somit kein unerwünschter Versatz gebildet wird, der auch durch eine Umhüllung nicht ausgeglichen werden kann, weisen zueinander gekehrte Schmalseiten der Kantenleiste und der Decklage eine Verbindungsprofilierung auf. Die Verbindungsprofilierung stellt sicher, dass beim Zusammenfügen der Bauteile der Leichtbauwand keine unerwünschten Absätze entstehen.

Nach einer bevorzugten Ausführungsform der Erfindung sind die Stützelemente als Stützplatten ausgebildet, die in die jeweiligen Nuten der gegenüberliegenden Deckplatten eingefasst sind. Vorteilhaft lässt sich die Montage vereinfachen, wenn die Stützplatten in einem ersten Schritt formschlüssig in die Nute eingesetzt werden und in einem zweiten Schritt stoffschlüssig, bspw. durch Aushärten eines Klebemittels bzw. eines Leims an den Deckplatten fixiert sind.

Nach einer Weiterbildung der Erfindung sind die Stützplatten in einem solchem Abstand zueinander angeordnet, dass eine ausreichende Stabilität der Leichtbauwand gegeben ist.

Dadurch, dass sich Hohlkammern zwischen den Stützplatten bzw. den außen liegenden Kantenleisten ausbilden, kann das Gewicht der Leichtbauplatte auf einfache Weise verringert werden. Vorzugsweise sind die Stützplatten in einem regelmäßigen gleichen Abstand zueinander angeordnet.
Nach einer Weiterbildung der Erfindung ist die Umhüllung durch Aufbringen einer kurzen und einer langen Umhüllungsbahn gebildet, wobei sich diese beiden Umhüllungsbahnen in einem Bereich einer der Deckplatten überlappen, der als Anschlag für ein weiteres mit der Leichtbauwand zu verbindendes Möbelteil bildet. Auf diese Weise können die Kanten der Leichtbauplatte bzw. die kantennahen Bereiche derselben frei von jeglichem Oberflächenversatz bzw. einer Oberflächennaht sein.
Nach einer Weiterbildung der Erfindung ist die Umhüllung als eine einstückige Folie oder als eine einstückige Papierlage ausgebildet, die durch Wärme und Druck auf die Oberfläche der Deckplatte sowie der Kantenleisten aufgebracht wird. Dadurch, dass die Dicke der Umhüllung relativ dünn ist, bleibt der Konturenverlauf der Leichtbauplatte unverändert. Auch wenn die Kantenleiste ein Dekorprofil aufweist, bleibt die Konturierung dieses Dekorprofils erhalten.

Zur Lösung der Aufgabe weist das erfindungsgemäße Verfahren die Merkmale des Patentanspruches 10 auf. Der Vorteil des erfindungsgemäßen Verfahrens besteht darin, dass auf einfach Weise eine stabile Leichtbauplatte mit einem relativ geringen Gewicht hergestellt werden kann, die eine homogene und glatte Oberfläche aufweist und die in einem Kantenbereich keinen unerwünschten sichtbaren Übergang oder einen Absatz aufweist. Das erfindungsgemäße Verfahren ermöglicht insbesondere die Bereitstellung einer bogenförmigen Kante, wobei eine Außenseite der Deckplatte kontinuierlich bzw. stetig in eine senkrecht zu derselben verlaufende Außenseite einer Kantenleiste übergeht.

Weitere Vorteile der Erfindung ergeben sich aus den weiteren Unteransprüchen.

Ausführungsbeispiele der Erfindung werden nachfolgend anhand der Zeichnungen näher erläutert.

Es zeigen:
- Figur 1: einen teilweisen Querschnitt durch eine Leichtbauplatte, die als eine Seitenwand für ein Möbelstück verwendet wird,
- Figur 2: eine schematische Ansicht der Leichtbauplatte gemäß Figur 1 in Richtung X,
- Figur 3: einen Querschnitt durch die gesamte Leichtbauplatte im verleimten, aber noch nicht umhüllten Zustand gemäß Figur 1,
- Figur 4.: eine vergrößerte Darstellung einer Profilverbindung in einem Kantenbereich der Leichtbauplatte,
- Figur 5: einen teilweisen Querschnitt einer Leichtbauplatte mit einer Kantenleiste eines ersten Dekorprofils,
- Figur 6: einen teilweisen Querschnitt einer Leichtbauplatte mit einer Kantenleiste eines zweiten Dekorprofils,
- Figur 7: einen teilweisen Querschnitt einer Leichtbauplatte mit einer Kantenleiste eines dritten Dekorprofils,
- Figur 8: einen Querschnitt durch eine nicht erfindungsgemäße Leichtbauplatte, die als ein Tischfuß verwendet wird, und
- Figur 9: einen Querschnitt durch eine nicht erfindungsgemäße dreieckförmige Leichtbauplatte.

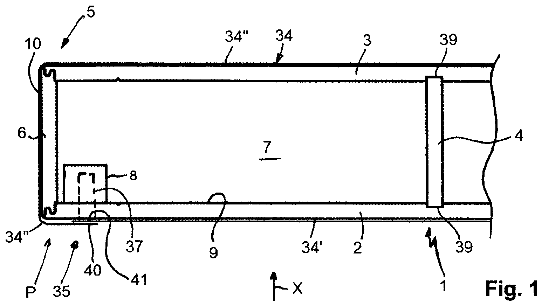

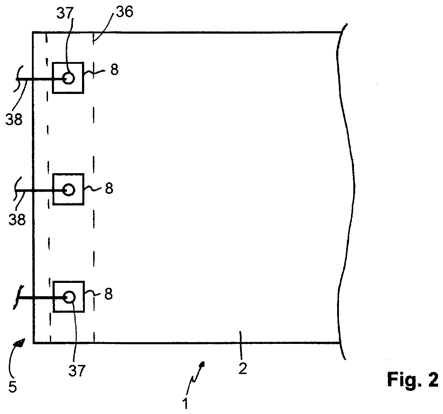

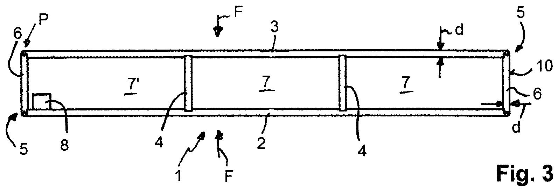

Eine Leichtbauplatte 1 nach einer ersten Ausführungsform der Erfindung gemäß den Figuren 1 bis 7 kann bspw. als eine Seitenwand für einen Schrank oder Regal eingesetzt werden.
Die Leichtbauplatte 1 weist eine erste Deckplatte 2 und eine parallel zu derselben verlaufende zweite Deckplatte 3 auf. Ein Abstand zwischen diesen beiden Deckplatten 2, 3 wird durch eine Anzahl von in einem Abstand zueinander, vorzugsweise parallel angeordneten Stützelementen 4 sowie an gegenüberliegenden Schmalseiten 5 der Leichtbauplatte 1 angeordneten Kantenleisten 6 vorgegeben.
Die erste Deckplatte 2 und die zweite Deckplatte 3 bilden jeweils eine Decklage der Leichtbauplatte 1 mit einer relativ großen Fläche. Die Stützelemente 4 sind als relativ dünnwandige Stützplatten ausgebildet, die etwa die gleiche Dicke aufweisen wie die Kantenleisten 6. Die Stützplatten 4 bilden eine Kernlage der Leichtbauplatte 1. Zwischen den Stützplatten 4 erstrecken sich Hohlräume 7. Die Stützplatten 4 sind in einem solchen Abstand zueinander angeordnet, dass die Leichtbauplatte 1 eine ausreichende Stabilität aufweist.
In einem randseitigen Hohlraum 7' ist zusätzlich eine Anzahl von Aufnahmeelementen 8 angeordnet, die zur Aufnahme von Befestigungsmitteln für weitere Möbelteile, bspw. einer Tür oder einer weiteren Leichtbauplatte, dienen. Das Aufnahmeelement 8 ist als ein Aufnahmeblock oder Aufnahmeklotz ausgebildet, der auf einer Innenseite 9 der ersten Deckplatte 2 mit derselben stoffschlüssig verbunden ist, bspw. durch Verleimung.

Nach einer alternativen Ausführungsform der Erfindung ist das Aufnahmeelement 8 sowohl an der Innenseite der ersten Deckplatte 2 als auch an einer Innenseite der zweiten Deckplatte 3 stoffschlüssig befestigt, bspw. durch Verleimung.

Nacht einer ersten Ausführungsform der Leichtbauplatte 1 gemäß den Figuren 1 bis 4 weist die Kantenleiste 6 eine ebene Oberfläche 10 auf.

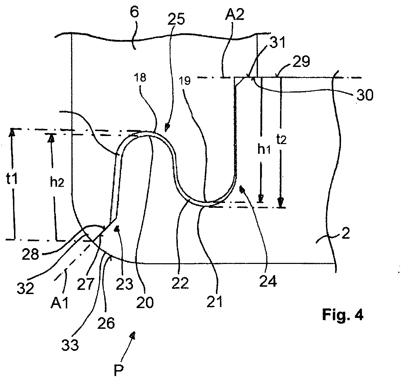

Wie besser aus Figur 4 ersichtlich ist, weist die Kantenleiste 6 und die erste Deckplatte 2 an ihrer Schmalseite eine Profilierung P auf. Die Kantenleiste 6 weist an ihrer Schmalseite eine Vertiefung 18 und eine benachbarte Erhebung 19 auf, die zu einer Erhebung 20 bzw. Vertiefung 21 der ersten Deckplatte 2 korrespondieren. Eine Tiefe t₁ der Vertiefung 18 und eine Höhe h₁ der Erhebung 19 ist so zu einer Höhe h₂ der Erhebung 20 und einer Tiefe t₂ der Vertiefung 21 abgestimmt, dass sich zwischen der jeweiligen Vertiefung 18 und Erhebung 20 bzw. Erhebung 19 und Vertiefung 21 ein Zwischenraum 22 zur Aufnahme eines Klebemittels bildet. Vorzugsweise wird als Klebemittel ein Leim verwendet, der sich kontinuierlich in dem Zwischenraum 22 verteilen kann. Der Zwischenraum 22 erstreckt sich quasi als wellenförmiger Kanal zwischen einem äußeren Ende 23 und einem inneren Ende 24 eines bogenförmigen Verbindungsabschnittes. Der Zwischenraums 22 erstreckt sich durchgehend von einem Ende zu einem anderen Ende der Schmalseite von Deckplatte 2 und Kantenleiste 6.

Die erste Deckplatte 2 und die zweite Deckplatte 3 weisen an ihren gegenüberliegenden Enden (Schmalseiten) die gleiche Profilierung P auf. Die Deckplatten 2 und 3 können somit als Gleichteile gefertigt werden. Auch die Kantenleisten 6, die an den gegenüberliegenden Schmalseiten der ersten Deckplatte 2 und der zweiten Deckplatte 3 angeordnet sind, weisen die gleiche Profilierung P auf. Die Kantenleisten 6 können somit auch als Gleichteile gefertigt werden.

An dem äußeren Ende 23 des eine Verhakung 25 bildenden bogenförmigen Verbindungsabschnittes schließt sich eine ebene Anschlagfläche 27 der Kantenleiste 6 und eine ebene Anschlagsfläche 28 der ersten Deckplatte 2 an. Die Anschlagfläche 27 der Kantenleiste 6 und die Anschlagfläche 28 der ersten Deckplatte 2 liegen unmittelbar aneinander an einer Außenseite 26 der Leichtbauplatte 1. Im Bereich einer Innenseite 29 der Leichtbauplatte schließt sich an dem inneren Ende des bogenförmigen Verbindungsabschnittes eine ebene Anschlagsfläche 30 der Kantenleiste 6 und eine korrespondierende ebene Anschlagsfläche 31 der ersten Deckplatte 2 an, die unmittelbar aneinander liegen. Die Anschlagfläche 27 und 28 erstrecken sich in einer Anschlagebene A1, die in einem spitzen Winkel zu einer Anschlagebene A2 verläuft, in der sich die Anschlagfläche 30 und 31 erstrecken.

Das Klebemittel kann sich somit nur in dem inneren Verbindungsabschnitt zwischen der Deckplatte 2, 3 und der Kantenleiste 6 vertiefen, wobei sie die Flächen der Vertiefungen 18, 21, bzw. Erhebungen 19, 20 benetzt.

Die Vertiefungen 18, 21 bzw. Erhebungen 19, 20 der Deckplatten 2, 3 sowie der Kantenleisten 6 verlaufen kontinuierlich bzw. stetig. Im Querschnitt können sie parabelförmig ausgebildet sein. Hierdurch ist gewährleistet, dass sich zwischen dem äußeren Ende 23 und dem inneren Ende 24 des Verbindungsabschnittes durchgehend das Klebemittel verteilen kann und eine innige und feste stoffschlüssige Verbindung zwischen der Deckplatte 2, 3 und der Kantenleiste 6 ermöglicht.

Die Vertiefungen 18, 21 bzw. Erhebungen 19, 20 weisen eine solche Tiefe t₁, t₂ bzw. Höhe h₁, h₂ auf, dass beim Zusammenfügen eine definierte Relativlage zwischen der ersten Deckplatte 2, 3 und der Kantenleiste 6 gewährleistet ist. Ein Nachjustieren ist nicht erforderlich. Dies wird begünstigt durch die in einem Winkel zueinander angeordneten Anschlagebenen A1, A2. Die Tiefe t₁ bzw. t₂ ist größer als die Höhe h₁ bzw. h₂, sodass stets der Zwischenraum 22 zwischen den Flächen der Vertiefung 18 und der Erhebung 19 der Kantenleiste 6 einerseits und der Erhebung 20 und Vertiefung 21 der Deckplatte 2, 3 andererseits beim Zusammenstecken gegeben ist.

Die Verbindungsprofilierung, die aus dem Vertiefungen 18, 21 und Erhebungen 19, 20 einerseits und den Anschlagflächen 27, 28, 30, 31 andererseits besteht, ermöglicht zuerst eine formschlüssige und dann eine stoffschlüssige Verbindung zwischen den Kantenleisten 6 einerseits und den Deckplatten 2, 3 andererseits. Grenzkanten 32 der Kantenleiste 6 einerseits und Grenzkanten 33 der Deckplatte 2 bzw. 3 andererseits liegen bündig aneinander, ohne dass sich ein Versatz oder Übergang zwischen der Kantenleiste 6 und der Deckplatte 2, 3 ergibt.

Die Tiefen t₁, t₂ bzw. die Höhen h₁, h₂ können in einem Bereich von 50% bis 80% einer Wanddicke d der Deckplatte 2, 3 oder der Kantenleiste 6 sein.

Damit die Leichtbauplatte 1 ein gewünschtes Erscheinungsbild aufweist, ist diese mit einer Umhüllung 34 versehen. Die Umhüllung 34 ummantelt die Leichtbauplatte 1 in Umfangsrichtung, wobei die gegenüberliegenden Kantenleisten 6 mit überdeckt werden. Ein Überlappungsbereich 35 der Umhüllung 34 ist in einem solchem Bereich der Leichtbauplatte 1 vorgesehen, der im montieren Zustand durch ein Möbelstück abgedeckt ist bzw. als Anschlag für ein weiteres zu verbindendes Möbelteil dient. Im vorliegenden Ausführungsbeispiel bildet der Überlappungsbereich 35 einen Randstreifen 36 der ersten Deckplatte 2, an dem sich innenseitig der ersten Deckplatte 2 die Aufnahmeklötze 8 in einem vorgegebenen Abstand zueinander erstrecken. Diese Aufnahmeklötze 8 weisen Bohrungen 37 auf, in denen Beschläge 38 des benachbarten Möbelteils, bspw. einer Tür, eingreifen können. Die Beschläge 38 können bspw. als Scharniere ausgebildet sein. Auf diese Weise befindet sich der Überlappungsbereich 35 in einem kantenfernen Bereich bzw. zu einem im Wesentlichen nicht sichtbaren Bereich der Leichtbauplatte 1. Die Bohrung 37 kann als eine Sackloch- oder Durchgangsbohrung zur Aufnahme des Befestigungsmittels ausgebildet sein, wobei diese Bohrung 37 zu einer Bohrung der ersten Deckplatte 2 fluchtet. Die Umhüllung 34 ist vorzugsweise einstückig ausgebildet.

Der Aufnahmeklotz 8 ist vorzugsweise ausschließlich mit der ersten Deckplatte 2 verbunden, wobei die Höhe des Aufnahmeblocks 8 von dem verwendeten Befestigungsmittel abhängt.

Zur Herstellung der Leichtbauplatte 1 wird die erste Deckplatte 2 an an einer Flachseite derselben angeordneten inneren Nuten 39 mit einem Klebemittel versehen, sodass danach die Stützplatten 4 unter formschlüssigem Eingriff in die jeweiligen Nut 39 sowie die Kantenleiste 6 an den Enden der ersten Deckplatte 2 angesetzt werden können. Allein aufgrund des Formschlusses sind die Klemmleisten 6 und die Stützplatten 4 an der ersten Deckplatte 2 gehalten. In einem zweiten Schritt wird die zweite Deckplatte an den freien gegenüberliegenden Enden der Kantenleiste bzw. über an einer Flachseite der zweiten Deckplatte 3 angeordneten Nuten 39 an die Stützplatten 4 angesetzt, wobei vorher an den Verbindungsstellen ein Klebemittel aufgetragen worden ist.

Anschließend wird durch Einwirken einer auf die erste Deckplatte 2 und die zweite Deckplatte 3 entgegengesetzt gerichtete Kraft F die Leichtbauplatte 1 verpresst. Nach Aushärtung des Klebemittels wird die Leichtbauplatte 1 dann mit der Umhüllung 34 versehen.

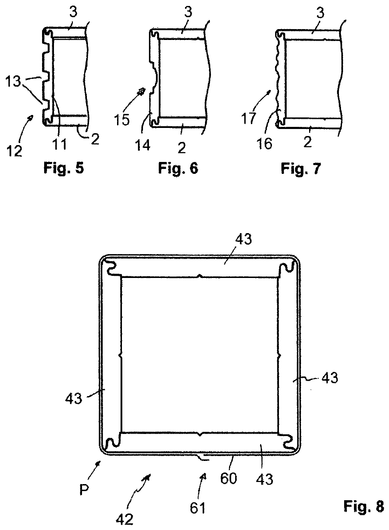

Wie insbesondere aus Figur 1 ersichtlich ist, besteht die Umhüllung 34 aus einer kurzen Umhüllungsbahn 34' und einer langen Umhüllungsbahn 34". Die kurze Umhüllungsbahn 34' wird auf eine Außenseite der ersten Deckplatte 2 aufgebracht. Die lange Umhüllungsbahn 34" wird danach auf eine Außenseite der zweiten Deckplatte 3 sowie den gegenüberliegenden Kantenleisten 6 aufgebracht, wobei ein Ende 40 der langen Umhüllungsbahn 34" in dem Randstreifen 36 der ersten Deckplatte 2 auf ein Ende 41 der kurzen Umhüllungsbahn 34' zur Anlage kommt. Durch Wärme und Druck wird dann eine konturfolgende Anlage der kurzen und langen Umhüllungsbahnen 34', 34" auf der Außenseite der Leichtbauplatte 1 erzielt. Die Umhüllung 34 kann bspw. aus einer Folie oder auch aus einer Papierlage bestehen.
Nach einer alternativen Ausführungsform der Erfindung gemäß Figur 5 kann eine Kantenleiste 11 mit einem ersten Dekorprofil 12 an der Oberfläche ausgebildet sein. Das erste Dekorprofil 12 besteht aus einer Anzahl von trapezförmigen Einschnitten 13, die sich beabstandet zueinander parallel zu den Deckplatten 2, 3 erstrecken.
Nach einer alternativen Ausführungsform gemäß Figur 6 kann eine Kantenleiste 14 mit einem zweitem Dekorprofil 15 ausgebildet sein, das eine flußbettartige Vertiefung aufweist, die sich mittig in Erstreckungsrichtung der Kantenleiste 14 verläuft.
Nach einer weiteren Ausführungsform der Erfindung gemäß Figur 7 kann eine Kantenleiste 16 ein drittes Dekorprofil 17 aufweisen, das eine wellenförmige Oberflächenstruktur aufweist.
Die Kantenleisten 6, 11, 14, 16 unterscheiden sich lediglich durch die außenseitige Oberflächenstruktur. Zur Verbindung mit der ersten Deckplatte 2 und der zweiten Deckplatte 3 weisen diese an ihren Schmalseiten eine gleiche Profilierung auf, die mit einer Profilierung der ersten Deckplatte 2 bzw. zweiten Deckplatte 3 zusammenwirkt.

Nach einer weiteren Ausführungsform nicht gemäß der Erfindung gemäß Figur 8 kann eine Stützeinheit, bspw. ein Fuß 42 für einen Tisch oder dergleichen vorgesehen sein. Der Fuß 42 unterscheidet sich im Wesentlichen von Leichtbauplatte 1 dadurch, dass er keine inneren Stützelemente 4 bzw. Aufnahmeelemente 8 aufweist. Der Fuß 42 weist lediglich vier Platten 43 auf, deren Schmalseiten die Profilierung P der Kantenleisten 6 bzw. der Deckplatten 2, 3 aufweisen. Diese Platten 43 sind außenseitig durch eine einstückige Umhüllung 60 ummantelt, wobei in einem kantenfernen mittleren Bereich einer Außenseite der Platte 43 ein Überlappungsbereich 61 gebildet wird.

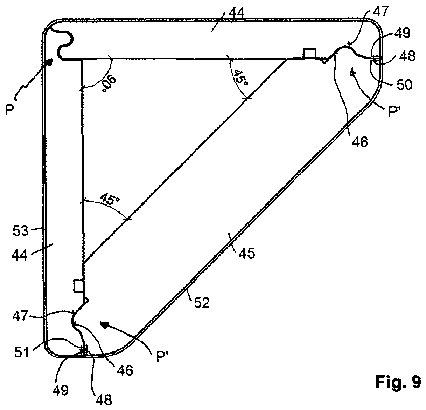

Nach einer weiteren alternativen Ausführungsform nicht gemäß der Erfindung gemäß Figur 9 kann eine Stützeinheit auch im Querschnitt dreieckförmig ausgebildet sein mit zwei gleichen Platten 44, die in einem rechten Winkel zueinander angeordnet sind, sowie einer schrägen Platte 45. Die Platten 44 weisen auf einer zueinander gekehrten Schmalseite die gleiche Profilierung P auf, wie in den vorgenannten Ausführungsbeispielen. An den hierzu gegenüberliegenden Schmalseiten sowie an den entsprechenden Schmalseiten der schrägen Platte 45 ist eine alternative Profilierung P' vorgesehen, die lediglich eine einzige Vertiefung 46 der Platten 44 und eine einzige Erhebung 47 bzw. der schrägen Platte 45 vorsieht. Äußere Anschlagflächen 48, 49 der Platten 44 bzw. schrägen Platte 45 im Bereich der Profilierung P' weisen eine solche Breite auf, dass Enden 50 einer kurzen Umhüllungsbahn 52, die eine Außenfläche der schrägen Platte 45 bedecken und Enden 51 einer lange Umhüllungsbahn 53, die beide Außenflächen 49 der Platten 44 überdecken zur Anlage kommen können. Die Umhüllung erfolgt bei dieser Ausführungsform, bevor die bereits zusammengefügten beiden Platten 44 mit der schrägen Platte 45 formschlüssig und stoffschlüssig verbunden werden.
Gleiche Bauteile bzw. Bauteilfunktionen der Ausführungsbeispiele sind mit den gleichen Bezugszeichen versehen.

## Patentansprüche

1. Leichtbauplatte für Möbel mit zwei Decklagen und einer zwischen den beiden Decklagen (2, 3) angeordneten Kernlage, mit einer Kantenleiste (6, 11, 14, 16), die an einer Schmalseite (5) der Leichtbauplatte (1) mit der Decklage (2, 3) verbunden ist,
- dass die Kernlage eine Anzahl von Stützelementen (4) aufweist, die sich zwischen einer ersten Decklage (2) und einer zweiten Decklage (3) erstrecken,
- dass die Kernlage eine Anzahl von Aufnahmeelementen (8) aufweist, die an einer Innenseite der ersten Decklage (2) und/oder der zweiten Decklage (3) angeordnet sind zur Aufnahme von Befestigungsmitteln zur Verbindung mit anderen Möbelteilen,
- dass die Kantenleiste (6, 11, 14, 16) und die erste Decklage (2) und die zweite Decklage (3) an zueinander gekehrten Schmalseiten derselben eine Profilierung (P) aufweisen, sodass eine Grenzkante (32) der Kantenleiste (6) einerseits und eine Grenzkante (33) der ersten Decklage (2) und der zweiten Decklage (3) andererseits im gefügten Zustand bündig aneinander liegen, **dadurch gekennzeichnet,**
- **dass** die erste Decklage (2) und die zweite Decklage (3) sowie die Kantenleiste (6, 11, 14, 16) mit einer Umhüllung (34) ummantelt sind, wobei freie Enden (40, 41) der Umhüllung (34) sich in einem Bereich der ersten Decklage (2) oder der zweiten Decklage (3) überlappen.

2. Leichbauplatte nach Anspruch 1, **dadurch gekennzeichnet, dass** die Decklagen (2, 3) jeweils durch Deckplatten gebildet sind und dass die Stützelemente (4) jeweils als Stützplatten ausgebildet sind, dessen gegenüberliegende Ränder in Nuten (39) der Deckplatten (2, 3) form- und/oder stoffschlüssig befestigt sind.

3. Leichtbauplatte nach Anspruch 2, **dadurch gekennzeichnet, dass** die Stützplatten (4) unter Bildung von Hohlkammern (7) parallel zueinander und parallel zu der Kantenleiste (6) verlaufen.

4. Leichtbauplatte nach einem der Ansprüche 1 bis 3, **dadurch gekennzeichnet, dass** die Umhüllung (34) durch eine kurze Umhüllungsbahn (34') und eine lange Umhüllungsbahn (34") gebildet ist, wobei die kurze Umhüllungsbahn (34') eine Außenseite der ersten Deckplatte (2) und die lange Umhüllungsbahn (34") eine Außenseite der zweiten Deckplatte (3) sowie die gegenüberliegenden Kantenleisten (6) und einen Randstreifen (36) der ersten Deckplatte (2) überdecken, wobei die freien Enden der kurzen Umhüllungsbahn (34') und der langen Umhüllungsbahn (34") sich an dem Randstreifen (36) der ersten Deckplatte (2) überlappen.

5. Leichtbauplatte nach einem der Ansprüche 1 bis 4, **dadurch gekennzeichnet, dass** die Umhüllung (34) als eine einstückige Folie oder als eine einstückige Papierlage ausgebildet ist, die durch Wärme und Druck aufbringbar ist.

6. Leichtbauplatte nach einem der Ansprüche 1 bis 5, **dadurch gekennzeichnet, dass** die Kantenleiste (11, 14, 16) außenseitig mit einem Dekorprofil (12, 15, 17) versehen ist.

7. Leichtbauplatte nach einem der Ansprüche 1 bis 6, **dadurch gekennzeichnet, dass** das Aufnahmeelement (8) als ein Aufnahmeblock ausgebildet ist, der eine Bohrung (37) zur Aufnahme des Befestigungsmittels aufweist, wobei die Bohrung (37) zu einer Bohrung der ersten Deckplatte (2), an der der Aufnahmeblock (8) befestigt ist, fluchtet.

8. Leichtbauplatte nach Anspruch 7, **dadurch gekennzeichnet, dass** der Aufnahmeblock (8) ausschließlich mit einer einzigen Deckplatte (2) verbunden ist.

9. Leichtbauplatte nach einem der Ansprüche 1 bis 8, **dadurch gekennzeichnet, dass** die erste Deckplatte (2) und die zweite Deckplatte (3) einerseits und die Kantenleiste (6) andererseits an ihren Enden die gleiche Profilierung (P) aufweisen.

10. Verfahren zur Herstellung einer Leichtbauplatte gemäß Anspruch 1 mit zwei Decklagen, mit einer zwischen den Decklagen verklebten Kernlage und mit an mindestens zwei Schmalseiten der Leichtbauplatte angeordneten Kantenleisten, die mit den Decklagen verklebt werden, **dadurch gekennzeichnet,**
- **dass** eine erste Deckplatte (2) über eine Nut (39) an einer Flachseite derselben mit einer Stützplatte (4) und über eine Profilierung (P) an einer Schmalseite derselben mit einer Kantenleiste (6) formschlüssig verbunden wird, wobei an Verbindungsstellen zwischen der ersten Deckplatte (2) einerseits und der Stützplatte (4) und der Kantenleiste (6) andererseits ein Klebemittel vorgesehen ist,
- **dass** die zweite Deckplatte (3) über eine Nut (39) an einer Flachseite derselben mit der freien Seite der Stützplatte (4) und über eine Profilierung mit der freien Seite der Kantenleiste (6) formschlüssig verbunden wird, wobei an Verbindungsstellen zwischen der zweiten Deckplatte (3) einerseits und der Stützplatte (4) und der Kantenleiste (6) andererseits ein Klebemittel vorgesehen ist,
- **dass** unter Einwirkung einer entgegengesetzt auf die erste Deckplatte (2) und die zweite Deckplatte (3) gerichteten Kraft (F) die Deckplatten (2, 3) verpresst werden,
- **dass** die so gebildete Leichtbauplatte (1) abschließend mit einer Umhüllung (34) versehen wird.

## Claims

1. A lightweight panel for furniture having two surface layers and a core layer arranged between the two surface layers (2, 3), having an edge strip (6, 11, 14, 16) which is connected on a narrow side (5) of the lightweight panel (1) to the surface layer (2, 3),
- the core layer has a number of supporting elements (4) which extend between a first surface layer (2) and a second surface layer (3),
- the core layer has a number of receiving elements (8) which are arranged on an inner side of the first surface layer (2) and/or of the second surface layer (3) for receiving fastening means for connecting to other pieces of furniture,
- the edge strip (6, 11, 14, 16) and the first surface layer (2) and the second surface layer (3) have a profiling (P) on narrow sides of the same which are turned towards one another, so that a boundary edge (32) of the edge strip (6), on the one hand, and a boundary edge (33) of the first surface layer (2) and of the second surface layer (3), on the other hand, lie on one another in a flush manner in the joined condition, **characterized in that**
- the first surface layer (2) and the second surface layer (3) as well as the edge strip (6, 11, 14, 16) are covered with a wrapper (34), wherein free ends (40, 41) of the wrapper (34) overlap in a region of the first surface layer (2) or of the second surface layer (3).

2. The lightweight panel according to Claim 1, **characterized in that** the surface layers (2, 3) are each formed by cover panels and that the supporting elements (4) are each configured as supporting panels, the opposite edges of which are fastened with a positive fit and/or in a firmly bonded manner in grooves (39) of the cover panels (2, 3).

3. The lightweight panel according to Claim 2, **characterized in that** the supporting panels (4) run parallel to one another and parallel to the edge strip (6), forming hollow chambers (7).

4. The lightweight panel according to any one of Claims 1 to 3, **characterized in that** the wrapper (34) is formed by a short wrapper web (34') and a long wrapper web (34"), wherein the short wrapper web (34') covers an outer side of the first cover panel (2) and the long wrapper web (34") covers an outer side of the second cover panel (3) as well as the opposite edge strips (6) and a marginal strip (36) of the first cover panel (2), wherein the free ends of the short wrapper web (34') and of the long wrapper web (34") overlap at the marginal strip (36) of the first cover panel (2).

5. The lightweight panel according to any one of Claims 1 to 4, **characterized in that** the wrapper (34) is configured as a one-piece film or as a one-piece paper layer which can be applied by means of heat and pressure.

6. The lightweight panel according to any one of Claims 1 to 5, **characterized in that** the edge strip (11, 14, 16) is provided on the outer side with a decorative profile (12, 15, 17).

7. The lightweight panel according to any one of Claims 1 to 6, **characterized in that** the receiving element (8) is configured as a receiving block which has a bore (37) for receiving the fastening means, wherein the bore (37) aligns with a bore of the first cover panel (2), to which the receiving block (8) is fastened.

8. The lightweight panel according to Claim 7, **characterized in that** the receiving block (8) is exclusively connected to a single cover panel (2).

9. The lightweight panel according to any one of Claims 1 to 8, **characterized in that** the first cover panel (2) and the second cover panel (3), on the one hand, and the edge strip (6), on the other hand, have the same profiling (P) at their ends.

10. A method for manufacturing a lightweight panel according to Claim 1, having two surface layers, having a core layer glued between the surface layers and having edge strips arranged on at least two narrow sides of the lightweight panel, which are glued to the surface layers, **characterized in that**
- a first cover panel (2) is positively connected by means of a groove (39) on a flat side of the same to a supporting panel (4) and by means of a profiling (P) on a narrow side of the same to an edge strip (6), wherein an adhesive is provided at connecting points between the first cover panel (2), on the one hand, and the supporting panel (4) and the edge strip (6), on the other hand,
- the second cover panel (3) is positively connected by means of a groove (39) on a flat side of the same to the free side of the supporting panel (4) and by means of a profiling to the free side of the edge strip (6), wherein an adhesive is provided at connecting points between the second cover panel (3), on the one hand, and the supporting panel (4) and the edge strip (6), on the other hand,
- the cover panels (2, 3) are pressed under the action of a force (F) which is directed opposite to the first cover panel (2) and the second cover panel (3),
- the lightweight panel (1) thus formed is finally provided with a wrapper (34).

## Revendications

1. Panneau de construction léger avec deux couches de recouvrement et une couche de coeur, disposée entre les deux couches de recouvrement (2, 3), avec une baguette de chant (6, 11, 14, 16), qui est reliée à la couche de recouvrement (2, 3), sur un côté étroit (5) du panneau de construction léger (1),
- la couche de coeur présentant un nombre d'éléments de support (4), qui s'étendent entre une première couche de recouvrement (2) et une deuxième couche de recouvrement (3).
- la couche de coeur présentant une pluralité d'éléments de réception (8), qui sont disposés sur une face intérieure de la première couche de recouvrement (2) et / ou de la deuxième couche de recouvrement (3) pour la réception de moyens de fixation destines à l'assemblage d'autres éléments de meubles,
- la baguette de chant (6, 11, 14, 16) de la première couche de recouvrement (2) et de la deuxième couche de recouvrement (3) présentant, sur des côtés étroits de celles-ci, orientés l'un vers l'autre, un profilage (P) tel qu'un bord limite (32) de la baguette de chant (6), d'une part, et un bord limite (33) de la première couche de recouvrement (2) et de la deuxième couche de recouvrement (3), d'autre part, affleurent l'un à l'autre à l'état assemblé,
**caractérisé en ce que**
- la première couche de recouvrement (2) et la deuxième couche de recouvrement (3), ainsi que la baguette de chant (6, 11, 14, 16) sont revêtues d'une enveloppe (34), sachant que des extrémités libres (40, 41) de l'enveloppe (34) se chevauchent dans une région de la première couche de recouvrement (2) ou de la deuxième couche de recouvrement (3).

2. Panneau de construction léger selon la revendication 1, **caractérisé en ce que** les couches de recouvrement (2, 3) sont respectivement formées par des plaques de recouvrement et que les éléments de support (4) sont respectivement réalisés sous la forme de plaques de support, dont les bords opposés sont fixés par engagement géométrique et / ou par liaison de matière dans des rainures (39) des plaques de recouvrement (2, 3).

3. Panneau de construction léger selon la revendication 2, **caractérisé en ce que** les plaques de support (4) s'étendent parallèlement les unes par rapport aux autres et parallèlement par rapport à la baguette de chant (6) en formant des chambres vides (7).

4. Panneau de construction léger selon l'une des revendications 1 à 3, **caractérisé en ce que** l'enveloppe (34) est composée d'une courte bande d'enveloppe (34') et d'une longue bande d'enveloppe (34"), sachant que la courte bande d'enveloppe (34') recouvre une face extérieure de la première plaque de recouvrement (2) et que la longue bande d'enveloppe (34") recouvre une face extérieure de a deuxième plaque de recouvrement (3) ainsi que les baguettes de chant (6) opposées et une bande de bord (36) de la première plaque de recouvrement (2), sachant que les extrémités libres de la courte bande d'enveloppe (34') et de la longue bande d'enveloppe (34") se chevauchent sur la bande de bord (36) de la première plaque de recouvrement (2).

5. Panneau de construction léger selon l'une des revendications 1 à 4, **caractérisé en ce que** l'enveloppe (34) est formée par un film réalisé d'une pièce ou par une couche de papier réalisée d'une pièce, qui peut être appliquée thermiquement ou par pression.

6. Panneau de construction léger selon l'une des revendications 1 à 5, **caractérisé en ce que** baguette de chant (11, 14, 16) est pourvue, sur sa face extérieure, d'un profilé décoratif (12, 15, 17).

7. Panneau de construction léger selon l'une des revendications 1 à 6, **caractérisé en ce que** l'élément de réception (8) est réalisé sous la forme d'un bloc de réception qui présente un alésage (37) destiné à la réception du moyen de fixation, sachant que l'alésage (37) est en alignement avec un alésage de la première couche de recouvrement (2), à laquelle le bloc de réception (8) est fixé.

8. Panneau de construction léger selon la revendication 7, **caractérisé en ce que** le bloc de réception (8) est exclusivement relié à une seule plaque de recouvrement (2).

9. Panneau de construction léger selon l'une des revendications 1 à 8, **caractérisé en ce que** la première plaque de recouvrement (2) et la deuxième plaque de recouvrement (3), d'une part, et la baguette de chant (6), d'autre part, présentent à leurs extrémités le même profilage (P).

10. Procédé de fabrication d'un panneau de construction léger selon la revendication 1, avec deux couches de recouvrement, avec une couche de coeur, collée entre les deux couches de recouvrement, et avec des baguettes de chant, qui, disposées sur au moins deux côtés étroits du panneau de construction léger, seront collées avec les couches de recouvrement, **caractérisé en ce que**
- une première plaque de recouvrement (2) est reliée en engagement géométrique, par l'intermédiaire d'une rainure (39), sur un côté plan de celle-ci, à une plaque de support (4) et, par l'intermédiaire d'un profilage (P), sur un côté étroit de celle-ci, à une baguette de chant (6), sachant qu'un agent adhésif est prévu à des points de liaison entre la première plaque de recouvrement (2), d'une part, et la plaque de support (4) et la baguette de chant (6), d'autre part,
- la deuxième plaque de recouvrement (3) est reliée en engagement géométrique, par l'intermédiaire d'une rainure (39), sur un côté plan de celle-ci, à une plaque de support (4) et, par l'intermédiaire d'un profilage (P), au côté libre de la baguette de chant (6), sachant qu'un agent adhésif est prévu à des points de liaison entre la deuxième plaque de recouvrement (3), d'une part, et la plaque de support (4) et la baguette de chant (6), d'autre part,
- sous l'effet d'une force antagoniste (F), dirigée la première plaque de recouvrement (2) et la deuxième plaque de recouvrement (3), les plaques de recouvrement (2, 3) sont comprimées,
- le panneau de construction léger (1) ainsi formé est ensuite pourvu d'une enveloppe (34).
